# EUROPEAN PATENT APPLICATION

(11) **EP 4 752 268 A1**
(43) Date of publication of application: **03.06.2026**
(21) Application number: 24216784.9
(22) Date of filing: 02.12.2024
(51) Int. Cl.: C30B 23/06, C30B 29/36

(54) **SEED CRYSTAL ASSEMBLY AND METHOD OF GROWING SIC SINGLE CRYSTAL BOULES**

(71) Applicant: SiCrystal GmbH, 90411 Nürnberg (DE)
(72) Inventor: BROX, Jan, 90411 Nürnberg (DE); ECKER, Bernhard, 90411 Nürnberg (DE); ECKSTEIN, Robert, 90411 Nürnberg (DE); VOGEL, Michael, 90411 Nürnberg (DE)
(74) Representative: Grünecker Patent- und Rechtsanwälte PartG mbB

(57) **Abstract**

The present invention relates to a seed crystal assembly for growing a single crystal boule in a physical vapor transport, PVT, process. Furthermore, the invention relates to a method for producing a bulk SiC crystal in a physical vapor transport growth system. A seed crystal assembly (136) comprises a base structure (138) which is connectable to a crucible (104), the base structure (138) having a base diameter (D) across a central axis (126) of the seed crystal assembly (136) and base height (H) along the central axis (126), and a single crystal seed crystal (112) which is designed for growing the single crystal boule on a growth surface (130). The single crystal seed crystal (112) is attached to the base structure (138), the seed crystal (112) having a seed crystal diameter (d) across the central axis (126) and a seed crystal height (h) along the central axis (126), wherein a specific heat conductivity of the base structure (138) differs by less than or equal to 25 % from a specific heat conductivity of the seed crystal (112) at a growth temperature between 2000 °C and 2600 °C.

## Description

The present invention relates to a seed crystal assembly for growing a single crystal boule in a physical vapor transport, PVT, process. Furthermore, the invention relates to a method for producing a bulk SiC crystal in a physical vapor transport growth system.

Due to its outstanding physical chemical and electrical properties silicon carbide is used inter alia as a semiconductor substrate material for power electronics semiconductor components, for radio frequency components and for a variety of special light emitting semiconductor components. Bulk SiC crystals with ideally pure and defect-free quality are required as a basis for these products.

As this is known in the art, bulk SiC crystals are generally produced by means of physical vapor deposition techniques, in particular using a sublimation method. Temperatures of more than 2000°C are required for this process. Physical vapor transport (PVT) is essentially a sublimation and re-condensation process, in which a source material and a seed crystal are placed inside a growth furnace in such a way that the temperature of the source material is higher than that of the seed, so that the source material sublimes and the vapor species diffuse and deposit onto the seed to form single crystals. An example of the PVT process is disclosed in US 8,865,324 B2.

For producing wafer-shaped substrates, the bulk SiC crystals are sliced e. g. by means of diamond impregnated wire saws. The surface is refined by subsequent multistage polishing steps. For fabricating electronic components, thin monocrystalline layers (e. g. SiC or GaN) are epitaxially deposited on the polished wafers. The characteristics of these layers and consequently of the electronic components fabricated therefrom decisively depend on the quality of the underlying SiC substrate.

A significant negative influence on the quality of SiC substrates results from stresses in the crystal lattice that can arise during crystal growth. These stresses lead to bending (bow, warp) of the SiC substrates produced from the bulk SiC crystal or also to dislocations, particularly in the basal plane (so-called BPD, i.e. basal plane dislocation), which can be caused by relaxation of the tension in the crystal lattice.

Stresses during SiC crystal growth can be caused, among other things, by stresses from the seed crystal assembly, the temperature gradients required for crystal growth, or mechanical stresses between the crucible wall and crystal during crystal growth or from cooling after growth.

In order to successively reduce the stress balance during the growth of SiC single crystals, all contributing components must be considered and improvement and remedial measures must be found for each individual cause.

In particular, the present disclosure aims at reducing the negative influence of the seed crystal and holder system (also referred to as seed crystal assembly in the following) on the stress balance during the growth of SiC single crystals. It should be noted that the principles of the present disclosure may also be applicable to improving the bulk crystal quality of other single crystals apart from silicon carbide. However, in the following SiC is always given as an example.

Conventionally, a monocrystalline SiC seed is fixed to a graphite seed crystal holder by bonding. The seed crystal holder serves as a support for the seed crystal with its contact surface in the growth setup. This mounting by a slidable support on a supporting surface of the crucible is shown in Figure 2. Alternatively, the seed crystal holder may also be clamped axially or radially in the growth assembly. The axial and radial clamping is illustrated in Figures 3 and 4, respectively. The bonding itself and the connection of two different materials in the seed holder-seed crystal system, in combination with the discontinuity of the transition from the edge of the SiC seed to the seed holder widened around the contact surface, causes inhomogeneous heat dissipation through the seed holder-seed crystal system.

For the growth of high-quality SiC single crystals, it is of crucial importance that the set temperature gradients, in particular the radial temperature gradient at the growth front, are not disturbed or altered by inhomogeneous heat dissipation. Incalculable temperature gradients and deviating temperatures on the seed surface suddenly lead to local lattice stresses in the SiC seed and to reduced quality of the grown single crystals.

When the crystal grows and/or cools after growth, these stresses remain in the crystal or partially relax due to the generation of basal plane dislocations. Remaining stresses can lead to bending (bow, warp) of SiC substrates produced from the single crystal boules. Dislocations also have a quality-reducing effect on the SiC substrates produced from the single crystal boules.

Known seed crystal assemblies are for instance shown in patents US 6723166 B2 or US 9590046 B2. According to US 6723166 B2, by laterally enclosing the seed holder, a seed holder seed system should be designed in such a way that the seed holder can be protected against the growth of SiC and a low-defect SiC crystal can be deposited on the SiC seed. However, it has been shown that inhomogeneous thermal coupling occurs and stresses and dislocations in the SiC crystal can be the result.

Further, US 9590046 describes a growth structure is designed in such a way that bending of the seed holder-seed crystal system is possible in order to take into account the different thermal expansion coefficients of SiC and graphite (bimetal effect). This can prevent delamination of the bond. However, the bending of the seed holder-germination system can cause uncontrolled stresses and dislocations in the crystal. When the grown single crystal boule is separated into SiC substrates, these stresses cause the single-crystal wafers to bend and warp (causing bow and warp). Excessively high bow and warp lead directly to rejection of the SiC substrates, as SiC substrates with low values for bow and warp are required for the subsequent epitaxy process.

Consequently, there is still a need for an improved seed crystal assembly and method of growing at least one SiC single crystal boule in a physical vapor transport, PVT, growth system, which overcomes the problems with existing systems and leads to single crystal boules with improved quality.

This object is solved by the subject matter of the independent claims. Advantageous embodiments of the present invention are the subject matter of the dependent claims.

The present disclosure provides a seed crystal assembly for growing a single crystal boule in a physical vapor transport, PVT, process, the seed crystal assembly comprising a base structure which is connectable to a crucible, the base structure having a base diameter across a central axis of the seed crystal assembly and base height along the central axis, and a single crystal seed crystal which is designed for growing the single crystal boule on a growth surface. The single crystal seed crystal is attached to the base structure, the seed crystal having a seed crystal diameter across the central axis and a seed crystal height along the central axis, wherein a specific heat conductivity of the base structure differs by less than or equal to 25 % from a specific heat conductivity of the seed crystal at a growth temperature between 2000 °C and 2600 °C. For instance, the specific heat conductivity of the base structure differs by less than or equal to 20 %, preferably by 15 %, from the specific heat conductivity of the seed crystal at a growth temperature between 2000 °C and 2600 °C.

By such a choice of materials, it can be avoided that the seed crystal is mechanically stressed during the heating process and thus the lattice of the growing single crystal boule has much less defects than when using conventional seed crystal assemblies.

For improving the uniformity of the temperature profile at the growth boundary surface, the seed crystal may form a step on the base structure, the step having a smaller diameter than a diameter of the base structure. This allows an improved heat dissipation, resulting in the desired temperature profile. For instance, the diameter of the seed crystal may be at least 2 mm smaller than the diameter of the base structure, and further, the diameter of the seed crystal may be not more than 10 mm smaller than the diameter of the base structure. Considering a ratio of the diameters, the ratio of the base diameter to the seed crystal diameter may be in a range between 1.05 and 1.2.

According to a further example of the present disclosure, the base structure has a first height along a central axis of the seed crystal assembly, wherein the seed crystal has a second height along the central axis, and wherein the base height is at least 1 mm larger than the seed crystal height. For example, the base height is not more than 5 mm larger than the seed crystal height. When considering a ratio of the two heights, the ratio of the base height to the seed crystal height may advantageously be in a range between 1.0 and 2.0.

According to a further advantageous example of the present disclosure, a surface of the base structure opposite to the seed crystal comprises a passivation layer comprising at least one of a carbonaceous layer, a refractory metal layer, and a graphite layer. Such a passivation layer of the back side surface of the base structure avoids an evaporation of components from the base structure. For instance, in case the base structure is formed from SiC, the evaporation of SiC at the elevated growth temperatures can be avoided by the passivation layer.

The advantageous similarity of the thermal conductivities of the seed crystal and the seed holder (also referred to as base structure) can be achieved either by a seed crystal assembly that is formed by at least two components which are joined together, or by a seed crystal assembly which is formed as one integral part.

For instance, the seed crystal assembly may be fabricated by means of vertical eroding or grinding.

According to another aspect of the present disclosure, a method of growing at least one SiC single crystal boule in a physical vapor transport, PVT, growth system is provided, the method comprising the steps of:
arranging an SiC powder source material in a source material compartment,
arranging at least one seed crystal assembly according to one of the preceding claims within a growth compartment, wherein the seed crystal comprises an SiC seed crystal and wherein the source material compartment is connected to the growth compartment for providing sublimated gaseous components to the growth compartment,
applying an elevated temperature between 2000 °C and 2600 °C for generating the sublimated gaseous components that generate an SiC growth phase at the SiC seed crystal, so that an SiC volume single crystal boule is formed at the SiC seed crystal.

Advantageously, the seed crystal assembly is mounted at the growth system by means of a freely suspended support, or the seed crystal assembly is mounted at the growth system by means of a clamping bearing.

The accompanying drawings are incorporated into and form a part of the specification to illustrate several embodiments of the present invention. These drawings together with the description serve to explain the principles of the invention. The drawings are merely for the purpose of illustrating the preferred and alternative examples of how the invention can be made and used and are not to be construed as limiting the invention to only the illustrated and described embodiments. Furthermore, several aspects of the embodiments may form-individually or in different combinations-solutions according to the present invention. Further features and advantages will become apparent from the following more particular description of the various embodiments of the invention, as illustrated in the accompanying drawings, in which like references refer to like elements, and wherein:

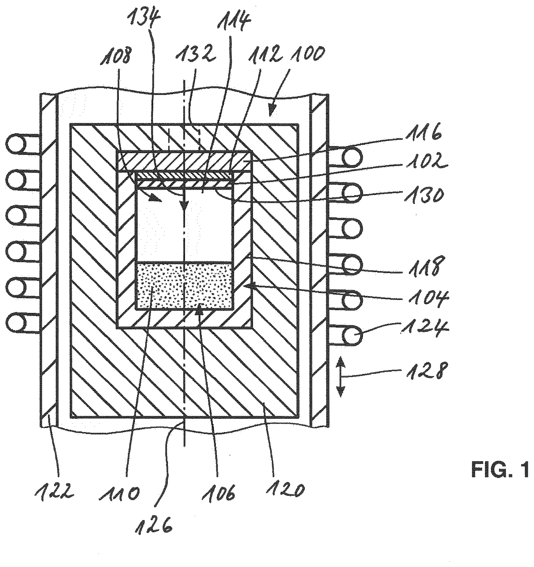

- **FIG. 1**: shows a schematic cross sectional view of a PVT growth apparatus;

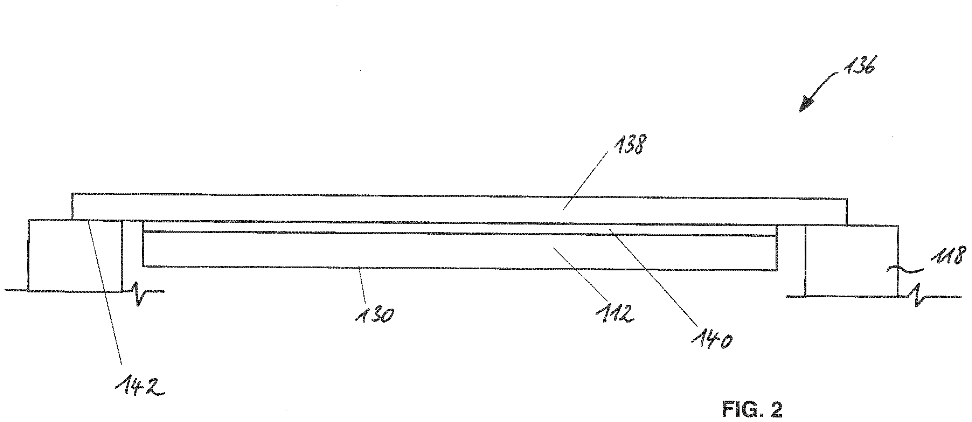

- **FIG. 2**: shows a schematic sectional view of a seed crystal assembly which is supported on a support surface;

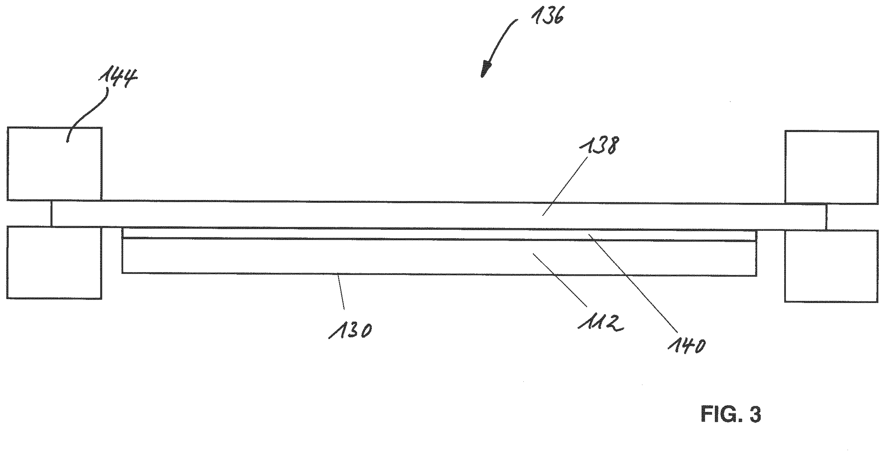

- **FIG. 3**: shows a schematic sectional view of a seed crystal assembly which is supported by an axial clamping;

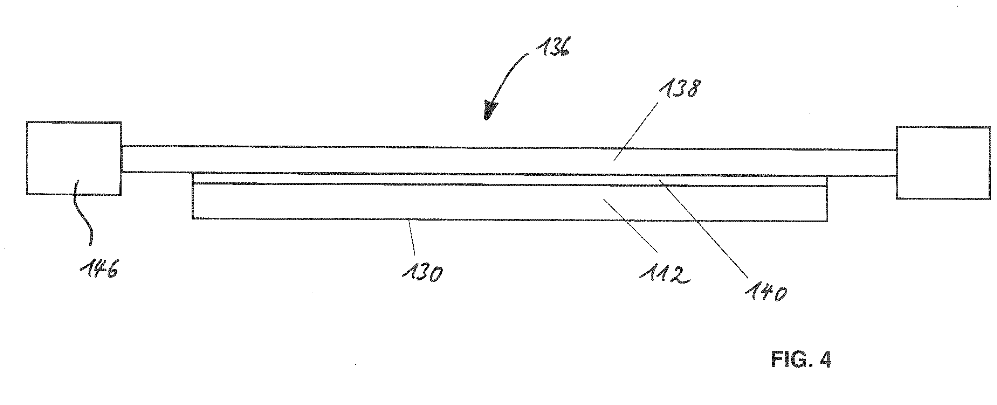

- **FIG. 4**: shows a schematic sectional view of a seed crystal assembly which is supported by a radial clamping;

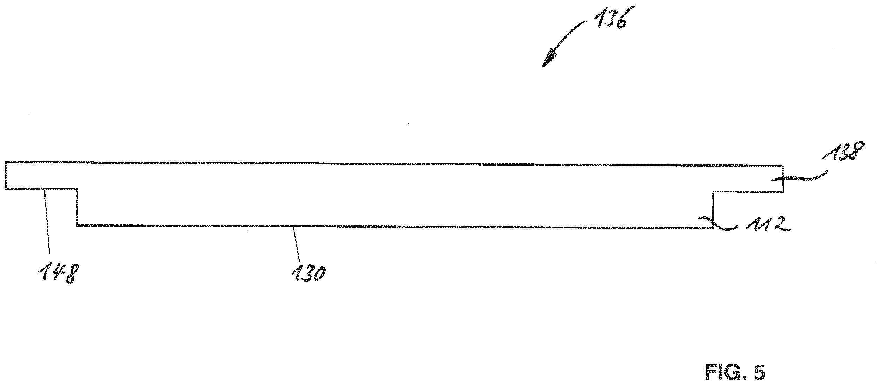

- **FIG. 5**: shows a schematic cross sectional view of a seed crystal assembly formed as an integral part;

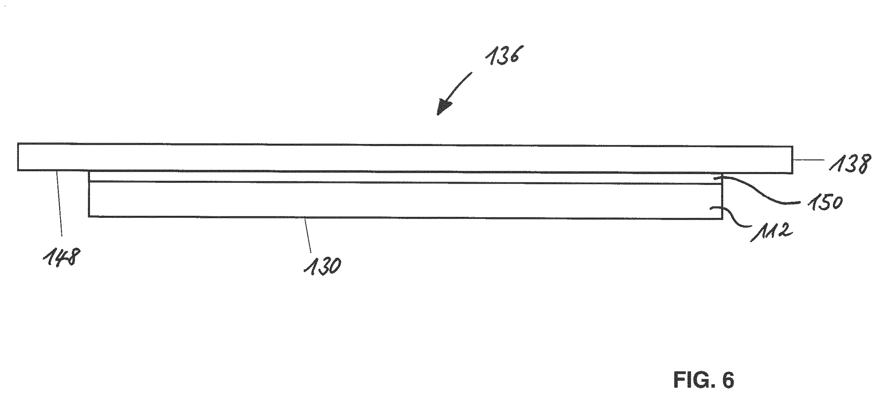

- **FIG. 6**: shows a schematic cross sectional view of a seed crystal assembly comprising separate parts;

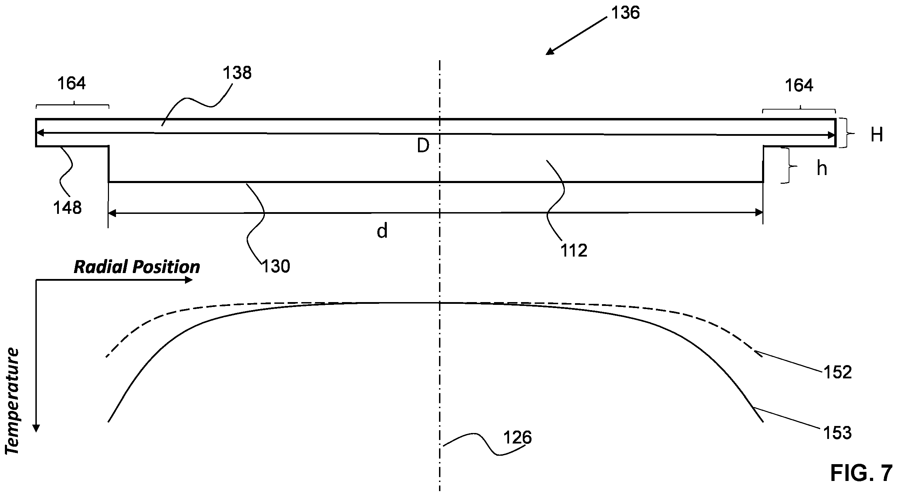

- **FIG. 7**: shows a schematic cross sectional view of a seed crystal assembly illustrating the temperature field at the growth front;

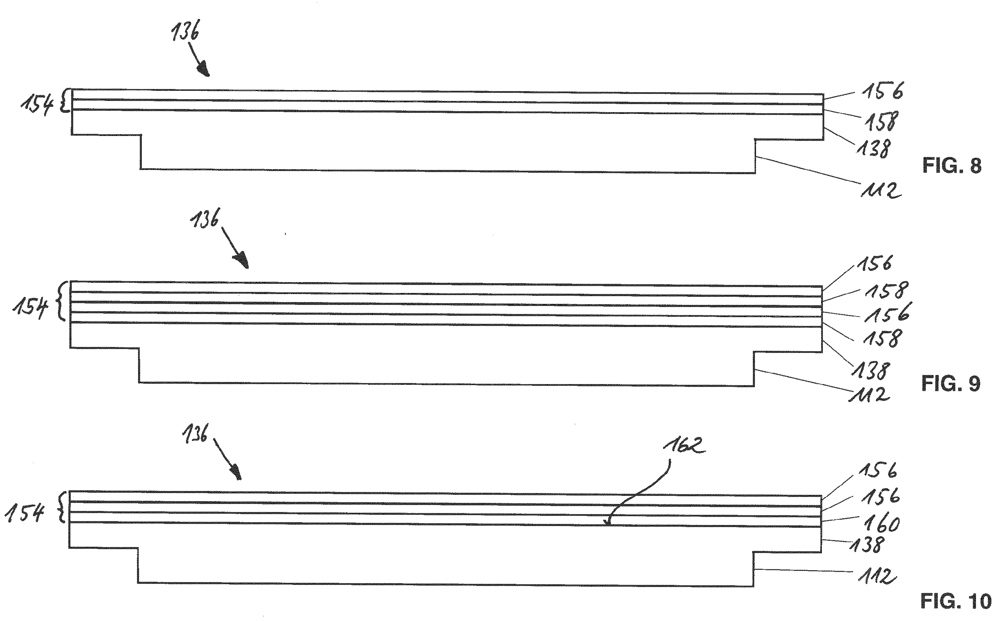

- **FIG. 8**: shows a schematic cross sectional view of a seed crystal assembly according to a further example;
- **FIG. 9**: shows a schematic cross sectional view of a seed crystal assembly according to a further example;
- **FIG. 10**: shows a schematic cross sectional view of a seed crystal assembly according to a further example.

The present invention will now be described in more detail with reference to the Figures. Turning first to Figure 1, there is shown a growth arrangement 100 for producing an SiC bulk single crystal 102 (also called single crystal boule or volume monocrystal) by sublimation growth. The growth arrangement 102 contains a growth crucible 104, which contains an SiC storage region 106 and a crystal growth region 108. Located in the SiC storage region 106 is, for example, powdery SiC source material 110, which is introduced as a prefabricated starting material before the beginning of the growth process into the SiC storage region 106 of the growth crucible 104.

An SiC seed crystal 112 extending axially into the crystal growth region 108 is provided in the region of a crucible end wall 116 of the growth crucible 104 opposing the SiC storage region 106. The SiC seed crystal 112 is, in particular, monocrystalline. Its structure and arrangement within the growth crucible 104 will be described in more detail below with reference to Figures 2 to 10.

The crucible end wall 116 is configured as a crucible lid of the growth crucible 104 in the example shown in Figure 1. This is not imperative, however. The SiC volume monocrystal 102 to be grown grows on the SiC seed crystal 112 by deposition from an SiC growth gas phase 114 forming in the crystal growth region 108. The growing SiC volume monocrystal 102 and the SiC seed crystal 112 have approximately the same diameter. If at all, there is a deviation of at most 10%, by which a seed diameter of the SiC seed crystal 112 is smaller than a monocrystal diameter of the SiC volume monocrystal 102. However, a gap, not shown in Figure 1, may be present between the inside of a crucible side wall 118, on the one hand, and the growing SiC volume monocrystal 102 and the SiC seed crystal 112, on the other hand.

The growth crucible 104 including the crucible lid 116, in the embodiment according to FIG. 1, may comprise an electrically and thermal conductive graphite crucible material with a density of, for example, at least 1.75 g/cm³. Arranged around it is a thermal insulation layer 10. The latter comprises, for example, a foam-like graphite insulation material, the porosity of which is, in particular, significantly higher than that of the graphite crucible material.

The thermally insulated growth crucible 104 may be placed inside a tubular container 122, which is designed as a quartz glass tube in the embodiment and forms an autoclave or reactor. To heat the growth crucible 104, an inductive heating device in the form of a heating coil 124 may be arranged around the container 11. Other suitable heating devices, such as resistive heaters, may of course also be used.

The growth crucible 104 is heated by the heating coil 124 to growth temperatures of more than 2000° C, preferably between 2000 °C and 2600 °C, in particular to about 2200° C. The heating coil 124 inductively couples an electric current into the electrically conductive crucible side wall 118 of the growth crucible 104. This electric current substantially flows as a circulating current in the peripheral direction within the circular and hollow cylindrical crucible side wall 118 and in the process heats the growth crucible 104. If necessary, the relative position between the heating coil 124 and the growth crucible 104 can be changed axially, i.e. in the direction of a central longitudinal axis 126 of the growing SiC volume monocrystal 102, in particular in order to adjust the temperature or the temperature profile within the growth crucible 104 and optionally also to change it.

The position of the heating coil 124 that can be axially changed during the growth process is indicated in Figure 1 by the double arrow 128. In particular, the heating coil 124 is displaced, adapted to the growth progress of the growing SiC volume monocrystal 102. The displacement preferably takes place downwardly, in other words, in the direction of the SiC source material 110, and preferably by the same length by which the SiC volume monocrystal 102 grows, for example in total by about 20 mm. For this purpose, the growth arrangement 100 contains correspondingly configured monitoring, control, and adjustment devices, not shown in more detail in the Figure.

The SiC growth gas phase 114 in the crystal growth region 108 is fed by the SiC source material 110. The SiC growth gas phase 114 contains at least gas constituents in the form of Si, Si₂C and SiC₂ (i.e. SiC gas species). The transport of the SiC source material 110 to a growth boundary surface 130 at the growing SiC volume monocrystal 102 takes place along an axial temperature gradient.

An axial temperature gradient measured in the direction of the central longitudinal axis 126 of at least 5 K/cm, preferably of at least 10 K/cm, is adjusted, in particular, at the growth boundary surface 130. The temperature within the growth crucible 104 decreases toward the growing SiC volume monocrystal 102. This can be achieved by various measures. Thus, an axially varying heating can be provided by dividing the heating coil 124 into two or more axial part portions (not shown in more detail).

Furthermore, a stronger heating effect can be adjusted in the lower portion of the growth crucible 104, for example by a corresponding axial positioning of the heating coil 124, than in the upper portion of the growth crucible 104. Moreover, the heat insulation at the two axial crucible end walls may be different. As indicated schematically in Figure 1, the thermal insulation layer 120 at the lower crucible end wall may, for this purpose, have a larger thickness than at the upper crucible end wall. Furthermore, it is possible for the thermal insulation layer 120 adjacent to the upper crucible end wall 116, to have a central cooling opening 132, through which heat is dissipated and which is arranged about the central longitudinal axis 126. The central cooling opening 132 is indicated in Figure 1 by dashed lines.

The SiC volume monocrystal 102 grows in a growth direction 134, which is oriented, in the example shown in Figure 1, from top to bottom, in other words from the crucible lid 116 to the SiC storage region 106. The growth direction 134 runs parallel to the central longitudinal axis 126. As the growing SiC volume monocrystal 102 in the embodiment shown is arranged concentrically within the growth arrangement 100, the central longitudinal axis 126 can also be allocated to the growth arrangement 100 as a whole.

Moreover, the SiC growth gas phase 114 also may contain doping substances, which are not shown in more detail in the view according to Figure 1, which are nitrogen (N₂) in this example. Alternative or additional doping substances such as, in particular aluminum (Al), vanadium (V), and/or boron (B) are also possible. The doping substance is supplied either in gaseous form or by the then accordingly pre-treated SiC source material 110. In this example, the SiC volume monocrystal 102 has an n-doping with nitrogen. The polytype may for instance be 4H-SiC. However, another doping or another SiC polytype is also possible

Figures 2 to 4 schematically illustrate in more detail how a seed crystal assembly 136 may be attached to the side wall 118 of the crucible 104. In these Figures the seed crystal assembly 136 is formed by a conventional seed holder 138 (also referred to as a base structure in the following). However, the mounting principles explained with reference to Figures 2 to 4 are intended to be also used with the seed crystal assembly according to the present disclosure and as described in more detail with reference to Figures 5 to 10. In conventional designs, the seed holder 138 is fabricated from graphite. The connection between the seed holder 138 and the monocrystalline SiC seed crystal 112 usually is achieved by an adhesive layer 140. As shown in Figure 2, the seed holder 138 is supported on a supporting surface 142 of the crucible side wall 118. Thus, the seed holder is slidable for compensating thermal expansion.

According to an alternative example as shown in Figure 3, the seed crystal assembly 136 is fixed by an axially clamping bearing 144. Such an axially clamping bearing 144 exerts clamping forces along the longitudinal axis 126 (see Figure 1). The axially clamping bearing 144 may comprise ring shaped fixing devices or a plurality of smaller fixing devices arranged around the circumference of the seed holder 138. Also a combination of one ring shaped and several smaller fixing devices is possible.

Further, as shown in Figure 4, the seed crystal assembly may also be mounted at the crucible by means of a radially clamping bearing 146. The radially clamping bearing 146 exerts forces that are directed radially inwards towards the center of the seed holder 138. The radially clamping bearing 146 may comprise a plurality of clamping elements distributed around the circumference of the seed holder 138. Alternatively, the radially clamping bearing 146 may also comprise a constrictable ring shaped clamping element.

Figure 5 illustrates a first example of a seed crystal assembly 136 according to the present disclosure. The aim of the present disclosure is to produce stress-reduced or stress-free crystals. To solve this problem, firstly a seed crystal/seed holder system, referred to as seed crystal assembly 136, as shown in Figure 5 is proposed. According to this aspect of the present disclosure, the seed crystal assembly 136 comprises a seed holder (also referred to as base structure) 138 and a seed crystal 112, which are both integrally formed from the same material, e. g. SiC.

By using such a three-dimensionally shaped SiC seed holder system, the crystal lattice of the SiC seed crystal remains unstressed during crystal growth. This means that less stress and less resulting dislocations in the grown crystal can occur during growth. The present disclosure is based on the use of a seed crystal holder system with optimum heat dissipation. Through targeted shaping, in particular of a one-piece SiC crystal, e.g. by die-sinking or grinding, a holder 138 can be produced for being supported on the support surface 148 or clamped by radial or axial clamping in the growth arrangement 100. The particular dimensions will be discussed in more detail with reference to Figure 7.

As an alternative to the integral design of Figure 5, the seed crystal assembly 136 may also be fabricated by joining two or more separate parts. As shown in Figure 6, the seed holder 138 and the seed crystal 112 can also be connected to form a seed crystal assembly 136 by bonding or special joining techniques from at least two geometries consisting of SiC. Importantly, the seed holder (or base structure) 138 is fabricated from a material having a thermal conductivity which is close to the thermal conductivity of the seed crystal 112. In particular, the thermal conductivity of the seed holder 138 at growth temperatures from 2000 °C to 2600 °C differs from the thermal conductivity of the seed crystal 112 by not more than 20 %, preferably not more than 15 %.

The interface layer 150 may be formed by various techniques. The bonding of two SiC bodies or one SiC body with another body of a different material can be performed by using mainly carbon-based glues or glues which results in mostly carbon containing bonding layer when cured. This can for example be of the groups of Novolac resins, phenolic resins in general, photoresists or other organic carbon-based molecules. Additionally, in the case of bonding of two SiC bodies, also the technique of using the adhesive forces can be applied to connect the two SiC bodies. A further technique is diffusion bonding. Diffusion bonding is a high-temperature and high-pressure process in which surfaces of two SiC parts are pressed together to bond through atomic diffusion. It does not use filler metals, making it highly reliable for applications where purity is critical.

Essentially, the present disclosure provides a seed crystal assembly 136 with optimized heat transport in order to keep the seed crystal without (or at least with less) mechanical stress during the high temperature PVT process. This aspect is particularly important during the starting and first growth interval of the growing monocrystal.

By controlling the respective thicknesses and diameters of the seed crystal assembly 136, the heat dissipation of the radial temperature gradient on the growth boundary surface 130 of the seed crystal 112 can be optimized. In particular, by correctly choosing the heights and diameters of the base structure 138 and the seed crystal 112, a balanced heat dissipation can be achieved in the edge and central areas of the seed crystal. As shown in Figure 7, the seed crystal assembly 136 has a step-shaped structure with the seed holder 138 having a first height H and the seed crystal 112 having second height h. The seed holder 138 e.g. has an essentially circular outline with a diameter D and the seed crystal is formed as an essentially circular step with a smaller diameter d. It should be noted that these geometric considerations also apply for the composite seed crystal assembly 136, not only for the integrally formed example shown in Figure 5.

In the cross-sectional view of Figure 7 the dashed line 152 symbolizes the temperature profile by showing the temperature across the seed crystal assembly 136. As can be seen from this profile, the temperature across the diameter d of the seed crystal 112 remains constant for a considerably large portion of the complete growth boundary surface 130. Thus, the mechanical stress is kept low within the lattice of the seed crystal 112. Further, because the seed holder 138 and the seed crystal 112 are fabricated from the same material, they do not differ in their thermal expansion characteristics, again reducing any mechanical stress between the seed holder 138 and the seed crystal 112. By controlling the dimensions H/h and D/d, a balanced heat dissipation can be achieved in the edge and central areas of the seed crystal 112. This is in contrast to the radial temperature field according to the state of the art, where only a non-balanced temperature field with a strong radial gradient can be achieved. Curve 153 illustrates the temperature profile which can be achieved when for instance using a conventional graphite seed holder to which the SiC seed crystal is attached by means of an adhesive.

The diameters D and d, as well as the heights H and h are chosen for controlling the optimum heat dissipation of the inhomogeneous temperatures at the seed crystal 112 due to the radial temperature gradient. According to the present invention, the geometry and material characteristics in particular of a peripheral transitional region 164 of the seed holder 138 allows a controlled heat dissipation in a radial and an axial direction. Thereby, the advantageous temperature profile symbolized by curve 152 can be achieved. In particular, the temperature can be kept constant of a much larger radial area.

Ideally, the ratio H/h is in the range of 1.0 to 2.0 and the ratio D/d is in the range of 1.05 to 1.20. The supporting surface 148 designed in this way thus also serves as a balancing body for controlling the heat transfer through the seed crystal assembly 136.

As mentioned above, the conventional use of different materials for the seed crystal and seed holder and the resulting interface due to the bonding or clamping (according to the state of the art) leads to a discontinuity in the heat dissipation in the axial direction through the seed crystal assembly, which can be avoided in the assembly according to the present disclosure.

Homogeneous heat dissipation or the avoidance of hotspots in the edge or central area of the seed means that the crystal lattice or the seed holder-germ system remains stress-free. Otherwise, the temperature-dependent coefficient of thermal expansion would lead to locally different expansions and/or compressions of the crystal lattice of the seed, which would continue into the growing crystal. The result would be a strained grown monocrystal. This can be avoided by using a seed crystal assembly 136 according to the present disclosure.

A further aspect of the present disclosure lies in a passivation of the rear side of the seed crystal assembly 136. This aspect will now be explained in detail referring to Figures 8 to 10. It should be noted that the Figures of the present disclosure are not to scale. All thin layers are shown with an exaggerated thickness for clarity reasons.

In particular, when the seed crystal assembly 136 is formed by an SiC seed holder system, a passivation layer 154 can be provided in order to prevent evaporation of SiC. The passivation of the back of the SiC seed holder 138 can be carried out in different ways.

Firstly, the passivation layer can be formed as a coating from a fluid solution (e.g. Novolac resin, phenolic resin, or the like). This solution is not depicted in the drawings.

Further, as shown in Figure 8, a foil 156 (e.g. made of expanded graphite) may be attached to the back of the seed holder 138 by means of a suitable adhesive layer 158. Instead of graphite the foil 156 may also be formed from an optionally carbidized refractory metal. The back of the seed holder 138 may be provided with a foil 156 of a refractory metal, e.g. tantalum, tungsten, niobium, molybdenum, rhenium, iridium, ruthenium, hafnium, or zirconium, or of a mixture of one or more refractory metals or a foil of one or more carbidized refractory metals (e.g. TaC, WC, ...). Alternatively, carbidization of the foil 156 can take place after joining the foil 156 and the backside of the seed holder 138.

Moreover, as shown in Figure 9, the seed holder 138 may also be provided with graphite and/or (carbidized) refractory metal foils to the back of the SiC seed holder with or without prior coating of the SiC seed holder back with mainly carbon-containing compounds, e.g. Novolac, phenolic resin, or any suitable photoresist. For attaching the foils to the seed holder's back surface, they can be fixed by clamping the foils during assembly of the growth assembly 100. As shown in Figure 9, the passivation layer 154 may e.g. comprise two or more foils 156 alternating with adhesive layers 158.

A further example of a passivation layer 154 is shown in Figure 10. According to this example, a coating with a carbon containing layer 160 is deposited directly onto the back surface 162 of the seed holder 138. At least one foil 156 comprising graphite and/or a refractory metal is deposited on the coating 160. When clamping the foils 156 by means of the crucible lid or any other suitable clamping device during assembly of the growth arrangement 100, no additional adhesive has to be applied between the foils 156. In Figure 10, two foils 156 are shown, but of course also more layers can be involved.

Any suitable combination of the examples explained with reference to Figures 8 to 10 can be used to form a passivation layer 154 on the back surface 162 of the seed holder 138. It is also noted that the various passivation concepts may be used with an integral seed crystal assembly 136 as well as with any kind of multi-part seed crystal assembly 136.

In summary, with the solutions according to the present disclosure, it is possible to reduce the generation of stresses which might be caused by the interaction of the seed crystal 112 with the seed holder 138 during the growth of a monocrystal, in particular a silicon carbide crystal, by using a stepped seed crystal assembly where the seed holder 138 is fabricated from a material with a heat conductivity close to the heat conductivity of the seed crystal 112 itself. Advantageously, the seed holder 138 is made from the identical material as the seed crystal 112, e.g. SiC. The seed holder 138 may even be monocrystalline like the seed crystal 112, in particular, the seed crystal assembly 136 may be formed integrally as one part.

This allows the quality and yield of the SiC substrates to be directly improved with regard to their use in downstream processes such as epitaxy, which require SiC substrates with low bending and/or warping and low base layer dislocation densities.

### Reference Numerals:

| **Reference Numeral** | **Description** |
|---|---|
| 100 | growth arrangement |
| 102 | bulk single crystal |
| 104 | growth crucible |
| 106 | storage region; source material compartment |
| 108 | crystal growth region; growth compartment |
| 110 | source material |
| 112 | seed crystal |
| 114 | growth gas phase |
| 116 | crucible end wall |
| 118 | crucible side wall |
| 120 | thermal insulation layer |
| 122 | container |
| 124 | heating coil |
| 126 | central longitudinal axis |
| 128 | variable position of heating coil |
| 130 | growth boundary surface |
| 132 | central cooling opening |
| 134 | growth direction |
| 136 | seed crystal assembly |
| 138 | seed holder; base structure |
| 140 | adhesive |
| 142 | supporting surface of crucible |
| 144 | axially clamping bearing |
| 146 | radially clamping bearing |
| 148 | supporting surface of seed crystal assembly |
| 150 | interface |
| 152 | temperature profile for seed crystal assembly 136 |
| 153 | temperature profile for known graphite seed holder |
| 154 | passivation layer |
| 156 | foil (graphite, refractory metal) |
| 158 | adhesive layer |
| 160 | coating with carbon containing layer |
| 162 | back surface of the seed holder |
| 164 | transitional region |
| H | height of base structure |
| h | height of seed crystal |
| D | diameter of base structure |
| d | diameter of seed crystal |

## Claims

1. Seed crystal assembly for growing a single crystal boule in a physical vapor transport, PVT, process, the seed crystal assembly (136) comprising:
a base structure (138) which is connectable to a crucible (104), the base structure (138) having a base diameter (D) across a central axis (126) of the seed crystal assembly (136) and base height (H) along the central axis (126),
a single crystal seed crystal (112) which is designed for growing the single crystal boule on a growth surface (130),
wherein the single crystal seed crystal (112) is attached to the base structure (138), the seed crystal (112) having a seed crystal diameter (d) across the central axis (126) and a seed crystal height (h) along the central axis (126), and
wherein a specific heat conductivity of the base structure (138) differs by less than or equal to 25 % from a specific heat conductivity of the seed crystal (112) at a growth temperature between 2000 °C and 2600 °C.

2. Seed crystal assembly according to claim 1, wherein the seed crystal (112) forms a step on the base structure (138), the step having a smaller diameter (d) than a diameter (D) of the base structure.

3. Seed crystal assembly according to claim 2, wherein the diameter (d) of the seed crystal (112) is at least 2 mm smaller than the diameter (D) of the base structure (138).

4. Seed crystal assembly according to claim 2 or 3, wherein the diameter (d) of the seed crystal (112) is not more than 10 mm smaller than the diameter (D) of the base structure (138).

5. Seed crystal assembly according to one of the preceding claims, wherein a ratio of the base diameter (D) to the seed crystal diameter (d) is in a range between 1.05 and 1.2.

6. Seed crystal assembly according to one of the preceding claims, wherein the base height (H) is at least 1 mm larger than the seed crystal height (h).

7. Seed crystal assembly according to claim 6, wherein the base height (H) is not more than 5 mm larger than the seed crystal height (h).

8. Seed crystal assembly according to one of the preceding claims, wherein a ratio of the base height (H) to the seed crystal height (h) is in a range between 1.0 and 2.0.

9. Seed crystal assembly according to one of the preceding claims, wherein the specific heat conductivity of the base structure (138) differs by less than or equal to 20 %, preferably 15 %, from the specific heat conductivity of the seed crystal (112) at a growth temperature between 2000 °C and 2600 °C.

10. Seed crystal assembly according to one of the preceding claims, wherein a back surface (162) of the base structure (138) opposite to the seed crystal (112) comprises a passivation layer (154) comprising at least one of a carbonaceous layer (160), a refractory metal layer (156), and a graphite layer (156).

11. Seed crystal assembly according to one of the preceding claims, wherein the seed crystal assembly (136) is formed by at least two components which are joined together.

12. Seed crystal assembly according to one of the claims 1 to 10, wherein the seed crystal assembly (136) is formed as one integral part.

13. Seed crystal assembly according to claim 12, wherein the seed crystal assembly (136) is fabricated by means of vertical eroding or grinding.

14. Method of growing at least one SiC single crystal boule in a physical vapor transport, PVT, growth system, the method comprising the steps of:
arranging an SiC powder source material (110) in a source material compartment (106),
arranging at least one seed crystal assembly (136) according to one of the preceding claims within a growth compartment (108), wherein the seed crystal (112) comprises an SiC seed crystal and wherein the source material compartment (106) is connected to the growth compartment (108) for providing sublimated gaseous components to the growth compartment (108),
applying an elevated temperature between 2000 °C and 2600 °C for generating the sublimated gaseous components that generate an SiC growth phase at the SiC seed crystal, so that an SiC volume single crystal boule is formed at the SiC seed crystal.

15. Method according to claim 13, wherein the seed crystal assembly (136) is mounted at the growth arrangement (100) by means of a freely suspended support or wherein the seed crystal assembly is mounted at the growth arrangement (100) by means of a clamping bearing.
